Europaisches Patentamt

**European Patent Office**

**Office européen des brevets**

(19)

(11) Publication number: **0 245 116**
A2

# EUROPEAN PATENT APPLICATION

(21) Application number: **87304123.0**

(22) Date of filing: **08.05.87**

(51) Int. Cl.⁴: **G 01 R 27/14, G 01 N 27/07**

(30) Priority: **08.05.86 AU 5811/86**

(43) Date of publication of application: **11.11.87**
**Bulletin 87/46**

(84) Designated Contracting States: **AT BE CH DE ES FR GB IT LI NL**

(71) Applicant: **Berger, Jenson and Nicholson Limited, Hoechst House Salisbury Road, Hounslow TW4 6JH (GB)**

(72) Inventor: **Bubb, Michael David, 2/11 Withecombe Street, Rozelle New South Wales - 2039 (AU)**

(74) Representative: **Pennant, Pyers et al, Stevens, Hewlett & Perkins 5 Quality Court Chancery Lane, London, WC2A 1HZ (GB)**

(54) **Apparatus and method for measuring resistivity.**

(57) A portable apparatus for measuring resistivity comprising:
i)   a voltage source,
ii)  a gel-state electrode which comprises a confined gel-state mass of high constant conductivity and a suitable conductive electrolyte, and
iii) a second electrode.
     The second electrode may be a gel-state electrode or a solid-state electrode comprising a metallic probe. Methods for using the apparatus are also described.
     The apparatus can be used to measure the resistivity of fibre reinforced plastics and coatings on metallic substrates, including reinforced concrete. The remaining effective life of a coating, for instance, may be calculated from the resistance values monitored by means of non-linear regression analysis and extrapolation.

ACTORUM AG

## APPARATUS AND METHOD FOR MEASURING RESISTIVITY

The invention relates to a portable apparatus and a method for measuring resistivity. The invention is particularly useful for measuring the resistivity of fibre reinforced plastics and coatings on metallic substrates, including reinforced concrete.

The atmospheric corrosion of steel, for example, is a process which can be prevented or at least inhibited by the application of a protective coating. However, all coatings deteriorate with time and thus have only a limited effective life span. The rate of deterioration depends upon the quality of the coating and the various effects of physical and electrochemical degradation or corrosion resulting from their environment.

The relationship between the resistivity of an organic coating on a metallic substrate and its anticorrosive performance is well known. In the laboratory, the effectiveness of such a coating can be evaluated by immersing the coated substrate in an electrolyte, linking the electrode comprised by that coated substrate with a reference electrode to form an electric cell, and measuring the contribution of the coating to the internal resistance of the cell. By applying a low voltage (d.c.) potential to a nonconductive coating on a metallic substrate which is placed in an aqueous medium, a measurement of resistivity can be obtained by extrapolation from a reading on a potentiometer or galvanometer. While such techniques give useful results under laboratory conditions, they are not really suitable for field testing and clearly still less suitable for the evaluation in the field of existing coatings on pipelines, vessels or other structures having limited or difficult access.

U.S. Patent No. 3,810,007 describes apparatus for automatically comparing the resistivity of a non-conducting coating on a metallic substrate to a predetermined standard minimum resistance. The apparatus includes a probe for providing electrical contact with the surface of the non-conducting coatings under test. The probe preferably comprises a sponge formed of felt or the like and which is saturated with a suitable electrolyte, such as potassium chloride. This technique has the disadvantage that it involves comparing measured values with a fixed standard and is not able to measure exact resistances directly. The use of a wet sponge probe also has disadvantages. The surface contact area of such probes can vary and this leads to current leakage and changes in electrical properties. All of this means that there is a poor level of reproducibility of readings. Other known types of electrode contacts, such as liquid-state interfaces, mercury interfaces and conductive colloids, are not suitable for use in the field. They are either not readily portable, give poor reproducibility of readings or cannot be repeatedly set-up, operated and dismantled within a reasonable period of time.

It is sometimes desired to measure the surface resistivity of fibre reinforced plastics in order to assess their anti-static properties. A conventional method (Australian Standard AS 1334.9 of 1982) for determining the electrical resistance of conveyor and elevator belting, for instance, involves passing an electric current through electrodes to the surface of a suitably prepared sample of the belting, and then measuring the resistance of the belting between the electrodes after a given period of time. The electrodes are in the form of two brass concentric rings. This method suffers from the disadvantage that in order to achieve accurate readings it is often necessary to improve the electrical contact between the electrodes and the sample of belting by the use of contact fluid and/or soft metal foil. The latter requirements can prove awkward and cumbersome with tests in the field, particularly where there is limited or difficult access.

The present invention provides a portable apparatus for measuring resistivity comprising:

i) a voltage source,

ii) a gel-state electrode which comprises a confined gel-state mass of high constant conductivity and a suitable conductive electrolyte, and

iii) a second electrode.

The present invention also provides a method for measuring the resistivity of a coating on a metallic substrate which comprises applying a voltage to a circuit comprising a gel-state electrode in contact with the surface of the coating and a second electrode in contact with the surface of an uncoated part of the metallic substrate, and monitoring the resistance values. This method can be used to measure the resistivity of reinforced concrete.

The present invention further provides a method for measuring the resistivity of fibre reinforced plastic which comprises applying a voltage to a circuit comprising a gel-state electrode in contact with the surface of the fibre reinforced plastic and a second electrode also in contact with the fibre reinforced plastic, and monitoring the resistance values.

The voltage source may comprise any means capable of supplying an applied potential of from 0 to 1000 volts d.c., and typically an applied potential of from 0 to 50 volts is adequate.

- 4 -

The gel-state electrode comprises a confined gel-state mass of high constant conductivity and a suitable conductive electrolyte. The use of silver/silver chloride or copper/copper sulphate electrodes is particularly preferred, although other types can be employed. The gel-state mass is confined, typically within a plastic disc or cup, so that it has a constant surface area. A surface area of from 0.5 to 25 $cm^2$ is particularly preferred. The gel-state electrode is most preferably and conveniently self-adhesive, perhaps by the addition of surrounding adhesive tape, since this helps to ensure that it makes good mechanical and electrical contact with a surface. Particularly suitable gel-state electrodes are those commonly used in electrocardiography. Such electrodes are readily available, relatively inexpensive and exhibit constant physical and electrical properties.

A particular advantage of gel-state electrodes is the reproducibility of their surface area. When gel-state electrodes of the same size can be used in a series of measurements, the actual surface area of the gel itself is a constant and becomes unimportant as a factor in the calculations. The measured resistance becomes a function of the electrode, i.e. the resistance measured is expressed as ohms per gel-state surface area.

The second electrode may be either a gel-state electrode or a solid-state electrode in the form of a metallic probe. The type of electrode used as the second electrode will depend upon the particular circumstances of the use.

Where the second electrode is a gel-state electrode, this is suitably of the type and form described above. The use of a gel-state electrode as the second electrode is particularly preferred for measuring the resistivity of fibre reinforced plastics.

Where the second electrode is a solid-state electrode, this is in the form of a metallic probe. The probe needs to have good mechanical strength and is suitably made from stainless steel and sharpened to a point. It should be well insulated and is preferably surrounded by an insulating layer of plastic, such as polyethylene or Nylon 66. The plastic insulating layer may conveniently be formed into the shape of a handle. The use of a solid-state electrode as the second electrode is particularly preferred for measuring the resistivity of coatings on metallic substrates, including concrete reinforced with metal.

The resistance values monitored will normally be within the range of from 0 to $10^{16}$ ohms. The apparatus is preferably provided with means for the visual display of the measured resistance values, either by analog or digital means. In a particularly preferred embodiment the apparatus also includes means for the automatic storage or recordal of the measured resistance values, for example in a RAM, for future data processing.

The apparatus is compact and relatively lightweight and is capable of giving highly reproducible results. It is portable and is especially suitable for testing in the field, particularly in areas which have limited or difficult access. For example, it is envisaged that the apparatus could be used for evaluating coatings on the interior or exterior of small diameter pipes, the jacket legs of off-shore oil platforms, tunnels and conduits, piles and jetties, marine vessels and antennae towers.

The method of the invention may be used to measure the resistivity of fibre reinforced plastics and of coatings on metallic substrates. The previously described apparatus is particularly suitable for use in

- 6 -

this method and the following description refers to such apparatus.

For measuring the resistivity of fibre reinforced plastics, the second electrode is preferably a gel-state electrode. It is possible to measure either the surface resistivity or the cross-sectional resistivity of a sheet of fibre reinforced plastic. Measurement of surface resistivity can be used to assess anti-static properties, while cross-sectional measurements can be employed to assess the extent of moisture penetration. When it is desired to measure surface resistivity, the two electrodes will be spaced apart on the same side of the sheet of fibre reinforced plastic. When measuring cross-sectional resistivity, the electrodes will be positioned on opposite sides of the sheet of fibre reinforced plastic. Before affixing the two gel-state electrodes, the part of the surface with which the electrodes are to make contact may be prepared by means of abrading or wiping with a solvent. Acetone is a suitable solvent, but others can be used.

For measuring the resistivity of a coating on a metallic substrate, the first gel-state electrode contacts the surface of the coating and the second electrode contacts an uncoated part of the metallic substrate. The second electrode is preferably, although not necessarily, a solid-state electrode in the form of a metallic probe. If necessary, a portion of the coating is scraped or chipped away or otherwise removed in order to expose an uncoated part of the underlying metallic substrate. The coating is then repaired once the measurement has been taken. Alternatively, access to the metallic substrate may be by use of existing electrical test points for cathodic protection or corrosion monitoring, or through permanently emplaced non-corrosive electrical test points. In some cases, the coating may have deteriorated to such an extent that areas of the metallic substrate are already exposed. Before affixing the gel-state electrode, the part of the surface of the coating with which the electrode is to make contact may be prepared by abrading or wiping with a suitable solvent. That part of the uncoated metallic substrate with which the solid-state electrode is to make contact may be prepared by means of abrading or scuffing with the tip of the metallic probe so as to remove any interfering oxide layers. If the second electrode is a gel-state electrode, the surface of the uncoated metallic substrate may be prepared as before by abrading or wiping with a solvent.

It is to be understood that the coating on the metallic substrate may be organic or inorganic. It might be, for example, a coating of paint. The method is also particularly suitable for measuring the resistivity of reinforced concrete. The presence of rust and/or cracking on the surface of a reinforced concrete structure indicates the failure of the concrete (coating) to prevent corrosion of the internal reinforcement (metallic substrate). The method can therefore be used to assess the rate and extent of corrosion in reinforced concrete. The gel-state electrode is placed on the surface of the concrete and the second electrode, generally a solid-state electrode, is placed in contact with the reinforcement means. An area of the concrete may need to be drilled through or chipped away in order to gain access to the reinforcement. In long-term structures which are to be frequently checked, permanent non-corroding electrical access points may be installed. It is known that the electrical resistivity of concrete decreases as the moisture content and chloride ion levels increase. The resistance values recorded will enable the corrosion rate of the reinforcement within the concrete to be assessed. Resistance values of less than 5000 ohms/cm$^2$ generally

indicate a very high corrosion rate, while values of more than 10000 ohms/cm$^2$ would normally indicate negligible corrosion.

The resistance values recorded will give information on the state of a sheet of fibre reinforced plastic or of a coating on a metallic substrate at a particular point in time. A series of readings taken over a period of time will enable the progress of any degradation or corrosion to be monitored. However, the resistance values may also be used to calculate the remaining effective life of the fibre reinforced plastic or coating by means of non-linear regression analysis and extrapolation. Corrective action can then be planned and carried out in due time.

The portable apparatus and method of the present invention are simple, accurate and capable of giving highly reproducible results. They enable the quality and integrity of fibre reinforced plastics and coatings on metallic substrates to be monitored in the field. They can also be used in the development of new fibre reinforced plastics and coating compositions, and techniques for applying the same, by providing a means for the ready evaluation and prediction of their performance and effective life span in the field.

There is currently a trend in the coatings industry towards applying ultra high build organic coatings of dry film thicknesses approaching 6 mm. It is virtually impossible to visually assess the performance of such coatings with any accuracy, and totally impossible when they exist in areas of limited or difficult access and perhaps poor lighting. The apparatus and method are particularly suitable for checking the performance of such coatings.

The apparatus will now be described in greater detail with reference to the accompanying drawings in which:-

Figure 1 shows the apparatus in use for measuring the resistivity of a coating on a metallic substrate.

Figure 2 shows the apparatus in use for measuring the cross-sectional resistivity of a sheet of fibre reinforced plastic.

Figures 3, 4, 5 and 6 are graphs plotted from the results obtained by the method of the Example.

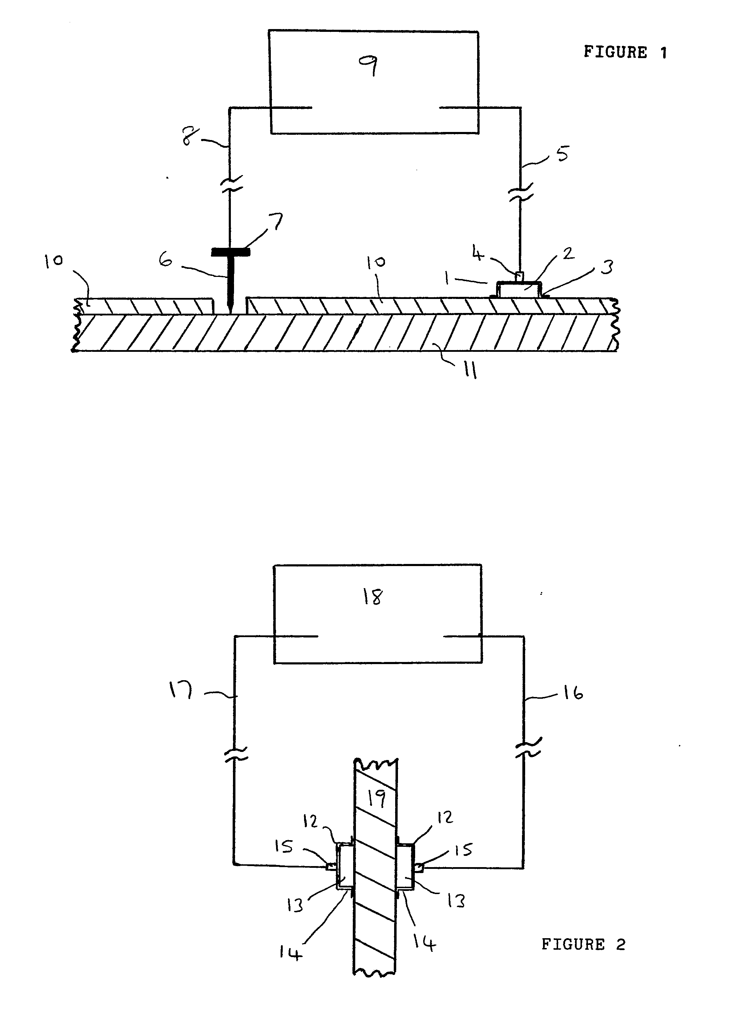

Referring to Figure 1, the apparatus includes a gel-state electrode 1 comprising a confined gel-state mass 2 and a surrounding strip of adhesive tape 3. The electrode is attached by means of an insulated low resistivity mechanical stud 4, typically of a clip-on clip-off construction, to a well insulated electrical conduit 5. The solid-state electrode 6 is in the form of a well insulated low resistance metallic probe made from stainless steel and sharpened to a point. Insulation for the probe is provided by a layer of plastic in the shape of a handle 7. The solid-state electrode is attached to a well insulated electrical conduit 8.

The two electrodes are each connected via their respective conduits to an instrument 9. It will be appreciated that the length of each conduit will depend upon the requirements and conditions of the operation. The instrument contains a voltage source and is preferably provided with means for the visual display of the measured resistance values and also means for the automatic storage or recordal of these values.

The gel-state electrode is in contact with the surface of a coating 10 on a metallic substrate 11. The solid-state electrode is in contact with an uncoated part of the metallic substrate.

Referring to Figure 2, the apparatus includes two gel-state electrodes 12 each comprising a confined gel-state mass 13 and a surrounding strip of adhesive tape 14. The electrodes are each attached by means of insulated low resistivity mechanical studs 15, typically of a clip-on clip-off construction, to well insulated electrical conduits 16, 17.

The two electrodes are each connected via their respective conduits to an instrument 18. It will be appreciated that the length of each conduit will depend upon the requirements and conditions of the operation. The instrument contains a voltage source and is preferably provided with means for the visual display of the measured resistance values and also means for the automatic storage or recordal of these values.

The gel-state electrodes are both in contact with the surface of a sheet of fibre reinforced plastic 19. The electrodes are positioned on opposite surfaces of the sheet for the purpose of measuring cross-sectional resistivity.

Referring to both Figures 1 and 2, in operation the voltage source is activated and a known voltage applied to the circuits shown. Resistance values are monitored from the instrument (9, 18).

The method will now be illustrated by the following example:-

Example

Two different high build polyester coatings (Coating 1 and Coating 2) were applied to grit-blasted panels of steel (Class 2½, 75 µm blast profile). Coating 1 was an organic peroxide cured unsaturated polyester resin modified with mica flake pigmentation of high build characteristics. Coating 2 was an organic

peroxide cured vinylester coating of high build characteristics containing a high level of inert lamellar pigments. The panels were left for 7 days at 25°C to attain full cure of the coatings. Coating 1 had an average dry film thickness of 710 µm and Coating 2 had an average dry film thickness of 2530 µm.

Initial resistivity measurements were recorded for the panels. Measurements were taken using the apparatus of this invention with a gel-state electrode and a solid-state second electrode in the form of a metallic probe. The probe was made from stainless steel and sharpened to a point. Part of the coating on the panel was drilled through or chipped away so that an area of the underlying steel was exposed. For each panel, the gel-state electrode was placed in contact with the surface of the coating and the solid-state electrode in contact with the surface of the exposed (uncoated) steel. Prior to each measurement, that part of the surface of the coating with which the gel-state electrode was to make contact was wiped with acetone, and that part of the surface of the uncoated steel with which the solid-state electrode was to make contact was scuffed or abraded with the tip of the probe. These preparations ensured good contact with the electrodes.

The panels were partially immersed in a 10% sodium hydroxide solution at 85°C in a sealed container. At various intervals, panels were removed from the container, rinsed with distilled water and allowed to dry at room temperature. The resistivity of the coatings on the panels was then measured in the manner described above at a temperature of about 24°C. Two measurements were taken for each panel, one from a point which had been immersed in the sodium hydroxide solution (wet) and another from a place which had been above the sodium hydroxide solution (dry).

Measurements were taken for panels bearing Coating 1 and Coating 2. The results are shown in the following table:-

| Immersion Time(hrs) | COATING 1 Resistance $\Omega/cm^2$ | | COATING 2 Resistance $\Omega/cm^2$ | |
|---|---|---|---|---|
| | Dry | Wet | Dry | Wet |
| 0 | $10^{12}$ | $10^{12}$ | $10^{12}$ | $10^{12}$ |
| 18 | $1.4 \times 10^{9}$ | $4.2 \times 10^{8}$ | $2.5 \times 10^{+8}$ | $7 \times 10^{+8}$ |
| 113.5 | $2.6 \times 10^{+8}$ | $1.5 \times 10^{+6}$ | $3 \times 10^{+8}$ | $4 \times 10^{+7}$ |
| 136 | $5 \times 10^{+8}$ | $2.5 \times 10^{+6}$ | $2.5 \times 10^{+8}$ | $1.8 \times 10^{7}$ |
| 145.5 | $3 \times 10^{+8}$ | $6.5 \times 10^{+6}$ | $1.5 \times 10^{7}$ | $2.8 \times 10^{6}$ |
| 159 | $8 \times 10^{+6}$ | N/R | $1.1 \times 10^{7}$ | $1.8 \times 10^{6}$ |

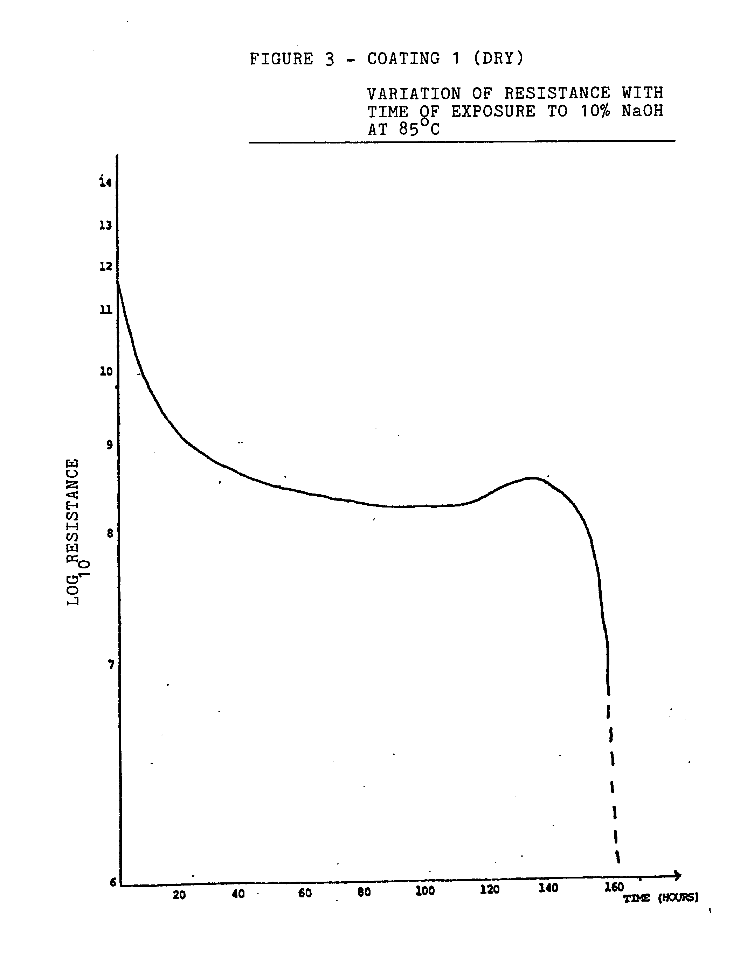

The results are presented graphically in Figures 3, 4, 5 and 6, in which the logarithm of the resistance is plotted against the time of immersion (exposure) in the sodium hydroxide solution.

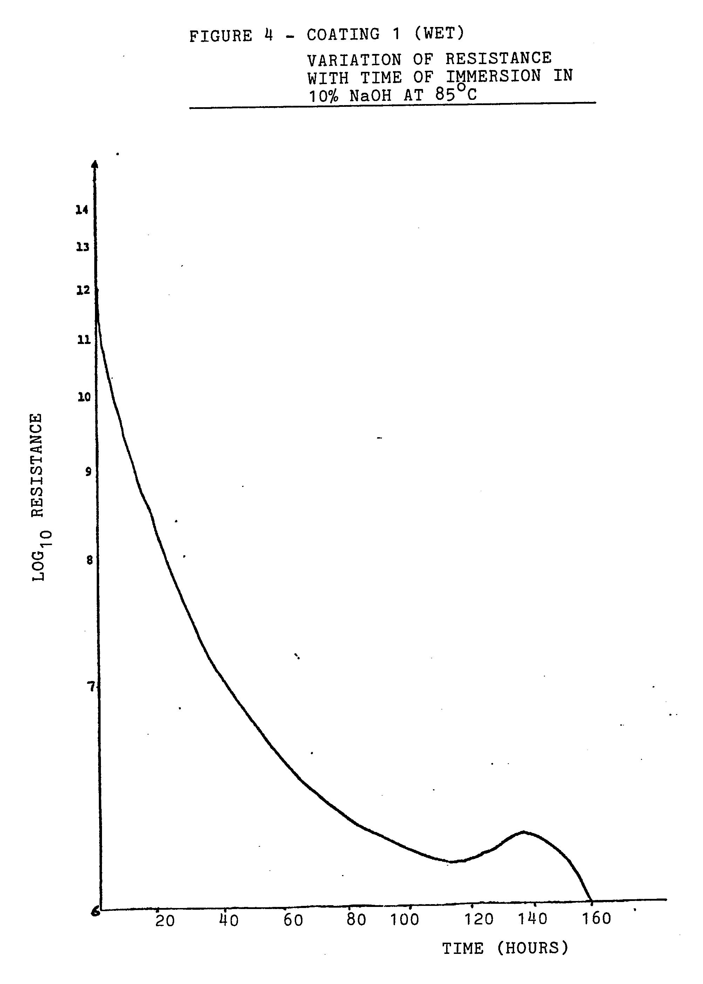

Figure 3 refers to Coating 1 and the measurements taken at various times on the dry (vapour phase) portion of the panels. The resistance remained of the order of $10^8$ ohms or better until about 140 hours of exposure above the sodium hydroxide solution, whereupon it fell rapidly. Figure 4 shows the performance of the same coating on the part of the panels which had been immersed in the sodium hydroxide solution. As might be expected, the resistance of the immersed portion of the coating decreased more rapidly than the dry portion. The resistance fell to less than $10^8$ ohms after only 18 hours of immersion.

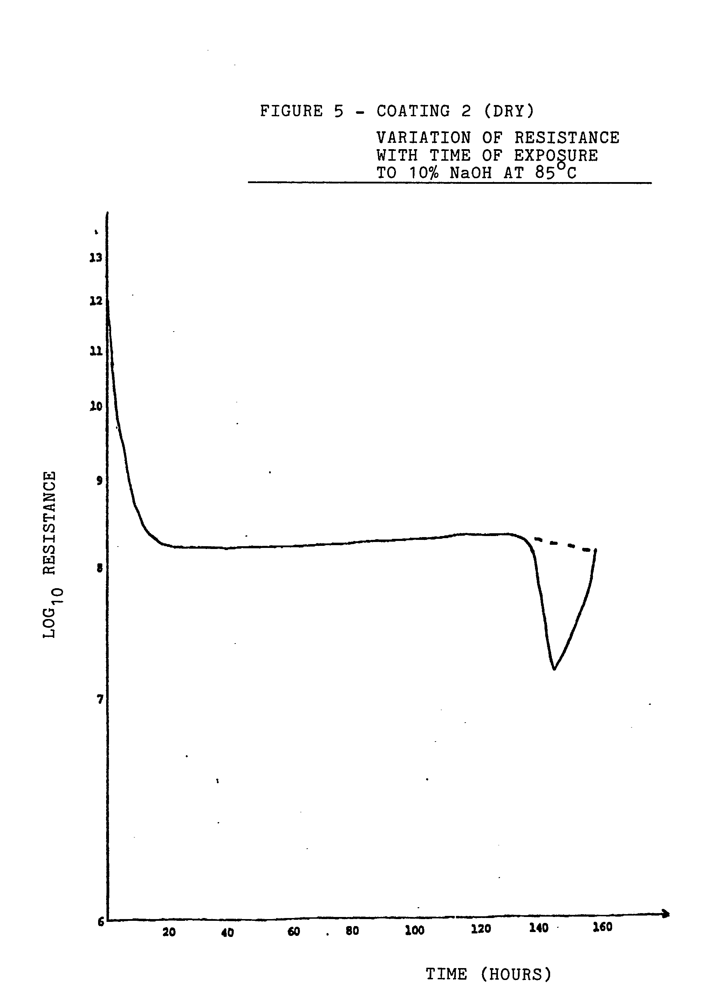

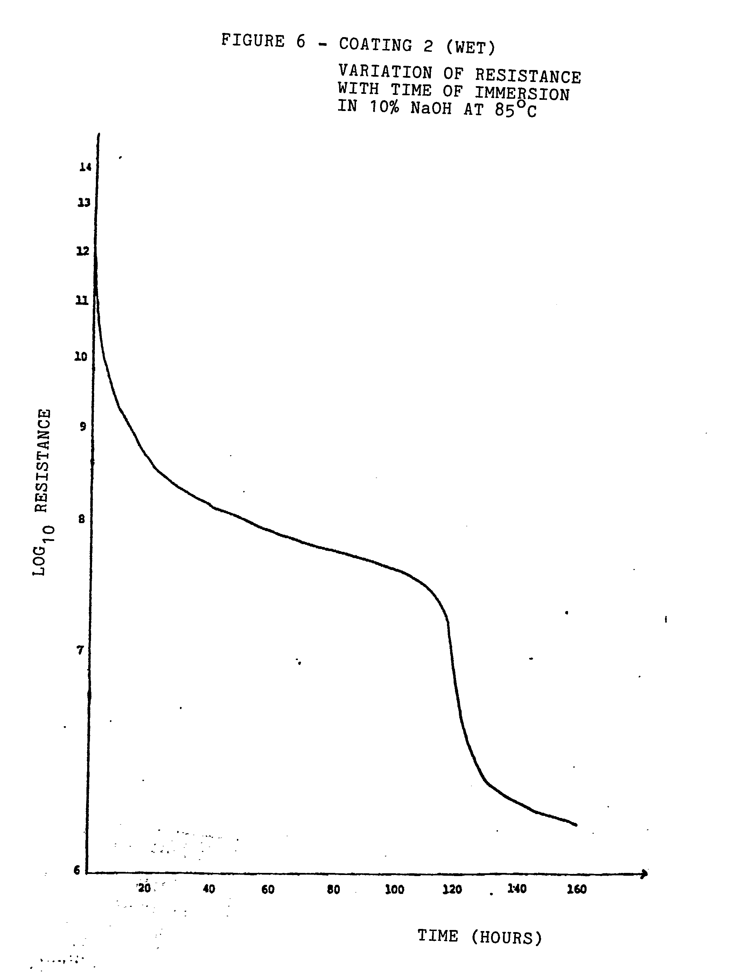

Figures 5 and 6 refer to Coating 2. This coating was of greater thickness than Coating 1 and it will be seen that in both Figures 5 (dry) and 6 (wet) the resistivity remains substantially constant for the first 120 hours of exposure/immersion in the sodium hydroxide solution. Coating 2 showed a greater ability to withstand immersion in the solution, but deteriorated rapidly after about 120 hours (Figure 6).

Generally, with a polyester coating on a steel substrate serious corrosion is beginning to occur when the resistivity falls below $10^7$ or $10^6$ ohms/$cm^2$. The coating is operating effectively at resistances of $10^9$ ohms/$cm^2$ and above.

CLAIMS

1.      A portable apparatus for measuring resistivity comprising:

i)      a voltage source,

ii)     a gel-state electrode which comprises a confined gel-state mass of high constant conductivity and a suitable conductive electrolyte, and

iii)    a second electrode.

2.      The apparatus as claimed in claim 1, wherein the second electrode is a gel-state electrode comprising a confined gel-state mass of high constant conductivity and a suitable conductive electrolyte.

3.      The apparatus as claimed in claim 1 or claim 2, wherein the gel-state electrode comprises a silver/silver chloride electrode or a copper/copper sulphate electrode.

4.      The apparatus as claimed in any of the preceding claims, wherein the confined gel-state mass of the gel-state electrode has a constant surface area of from 0.5 - 25 $cm^2$.

5.      The apparatus as claimed in any of the preceding claims, wherein the gel-state electrode is self-adhesive.

6.      The apparatus as claimed in claim 1, wherein the second electrode is a solid-state electrode comprising a metallic probe.

7.      The apparatus as claimed in claim 6, wherein the solid-state electrode comprises a probe formed from stainless steel and sharpened to a point.

8.     The apparatus as claimed in claim 6 or claim 7, wherein the solid-state electrode comprises a probe surrounded by an insulating layer of plastic.

9.     The apparatus as claimed in any of the preceding claims, wherein the voltage source is capable of supplying an applied potential of from 0 to 50 volts (d.c.).

10.     The apparatus as claimed in any of the preceding claims, wherein there is provided means for the visual display of the measured resistance values.

11.     The apparatus as claimed in any of the preceding claims, wherein there is provided means for the automatic storage or recordal of the measured resistance values.

12.     The apparatus as claimed in any of the preceding claims for use in measuring the resistivity of a coating on a metallic substrate.

13.     The apparatus as claimed in any of claims 1 to 11 for use in measuring the resistivity of fibre reinforced plastic.

14.     A method for measuring the resistivity of a coating on a metallic substrate which comprises applying a voltage to a circuit comprising a gel-state electrode in contact with the surface of the coating and a second electrode in contact with the surface of an uncoated part of the metallic substrate, and monitoring the resistance values.

15.     A method as claimed in claim 14, wherein the coating is concrete and the metallic subtrate is a reinforcement within the concrete.

16.     A method for measuring the resistivity of fibre reinforced plastic which comprises applying a voltage to a circuit comprising a gel-state electrode in contact with the surface of the fibre reinforced plastic and a second electrode also in contact with the fibre reinforced plastic, and monitoring the resistance values.

17.       A method as claimed in claim 16, wherein the second electrode is in contact with the reverse surface of the fibre reinforced plastic.

18.       A method as claimed in any of claims 14 to 17, wherein the second electrode is a gel-state electrode.

19.       A method as claimed in any of claims 14 to 17, wherein the second electrode is a solid-state electrode comprising a metallic probe.

20.       A method as claimed in any of claims 14 to 19, wherein that part of the surface with which the gel-state electrode is to make contact is previously prepared by means of abrading or wiping with a solvent.

21.       A method as claimed in claim 19, wherein that part of the surface with which the solid-state electrode in the form of a metallic probe is to make contact is previously prepared by means of abrading or scuffing with the tip of the probe.

22.       A method as claimed in any of claims 14 to 21, wherein the resistance values monitored are used to calculate the remaining effective life of the coating or fibre reinforced plastic by means of non-linear regression analysis and extrapolation.

FIGURE 1

FIGURE 2

0245116

FIGURE 3 - COATING 1 (DRY)

VARIATION OF RESISTANCE WITH
TIME OF EXPOSURE TO 10% NaOH
AT 85°C

FIGURE 4 - COATING 1 (WET)

VARIATION OF RESISTANCE
WITH TIME OF IMMERSION IN
10% NaOH AT 85$^{\circ}$C

FIGURE 5 - COATING 2 (DRY)

VARIATION OF RESISTANCE
WITH TIME OF EXPOSURE
TO 10% NaOH AT 85°C

FIGURE 6 – COATING 2 (WET)

VARIATION OF RESISTANCE
WITH TIME OF IMMERSION
IN 10% NaOH AT 85°C

TIME (HOURS)